# EUROPEAN PATENT APPLICATION

(11) **EP 4 567 891 A1**
(43) Date of publication of application: **11.06.2025**
(21) Application number: 23220472.7
(22) Date of filing: 28.12.2023
(51) Int. Cl.: H01L 27/12

(54) **ARRAY SUBSTRATE AND DISPLAY PANEL**

(30) Priority: 08.12.2023 CN 202311693063
(71) Applicant: Shenzhen China Star Optoelectronics Semiconductor Display Technology Co., Ltd., Shenzhen, Guangdong 518132 (CN)
(72) Inventor: ZHANG, Peng, Shenzhen, 518132 (CN); HSU, Yuanjun, Shenzhen, 518132 (CN)
(74) Representative: Nederlandsch Octrooibureau

(57) **Abstract**

Both an array substrate and a display panel include: a substrate having a pixel area and a capacitor area; a first thin film transistor disposed in the pixel area, the first thin film transistor including a first active layer, a first gate layer disposed on a side of the first active layer close to or away from the substrate, and a first source-drain layer disposed on a side of the first active layer away from the substrate, the first source-drain layer being electrically connected to the first active layer; and a first capacitor including a first plate, a second plate, and a first dielectric layer disposed between the first plate and the second plate, the first dielectric layer including a first sub-dielectric layer, and a second sub-dielectric layer disposed on a side of the first sub-dielectric layer close to the first active layer.

## Description

### FIELD

The present disclosure relates to display technologies, and in particular, to an array substrate and a display panel.

### BACKGROUND

**A** panel such as an Organic Light-Emitting Diode (OLED) panel is simple in structure, low in production cost, energy-saving, flexible, and wide in application range.

**A** pixel drive circuit of a panel such as an OLED panel generally includes a storage capacitor for storing a gray scale voltage to determine a drive current. If the storage capacitor is too small, luminance of a light-emitting device will be reduced. However, if a dual-layer or multi-layer capacitor structure is provided to increase capacitance, the number of processes of manufacturing a panel will be increased. If a relative area of two plates of a capacitor is increased to increase capacitance, a sub-pixel will occupy an increased area, which is not conductive to manufacture of a high-resolution product.

Therefore, storage capacitance in a conventional OLED panel cannot be set large, and there is an urgent need for improvement.

### SUMMARY

An object of the present disclosure is to provide an array substrate and a display panel, so as to solve a problem that storage capacitance in a conventional OLED panel cannot be set large
According to one or more embodiments of the present disclosure, an array substrate includes: a substrate having a pixel area and a capacitor area; a first thin film transistor disposed in the pixel area, the first thin film transistor including a first active layer, a first gate layer disposed on a side of the first active layer close to or away from the substrate, and a first source-drain layer disposed on a side of the first active layer away from the substrate, the first source-drain layer being electrically connected to the first active layer; and a first capacitor including a first plate, a second plate, and a first dielectric layer disposed between the first plate and the second plate, the first plate and the second plate being disposed on different layers, opposite to each other, and being disposed in the capacitor area, the first dielectric layer including a first dielectric sub-layer, and a second dielectric sub-layer disposed on a side of the first dielectric sub-layer close to the first active layer, the second dielectric sub-layer being disposed in the pixel area and the capacitor area, dielectric constant of the first dielectric sub-layer being greater than dielectric constant of the second dielectric sub-layer, and an orthographic projection of the first active layer on the substrate being disposed in an orthographic projection of the second dielectric sub-layer on the substrate.

According to one or more embodiment of the present disclosure, the first dielectric sub-layer comprises at least one of aluminum oxide or zirconium oxide, and the second dielectric sub-layer comprises silicon oxide.

According to one or more embodiment of the present disclosure, the first gate layer is disposed on the side of the first active layer away from the substrate; the first plate and the first gate layer are disposed in a same layer and comprise a same material; and the second plate is disposed on a side of the first plate away from the substrate or on a side of the first plate close to the substrate.

According to one or more embodiment of the present disclosure, the second plate is disposed on the side of the first plate away from the substrate; and the second plate is disposed between the first plate and the first source-drain layer, or the second plate and the first source-drain layer are disposed in a same layer.

According to one or more embodiment of the present disclosure, the second plate is disposed on the side of the first plate close to the substrate; the first thin film transistor further comprises a gate insulating layer disposed between the first active layer and the first gate layer to be opposite to the first gate layer; and the first dielectric layer and the gate insulating layer are disposed in a same layer.

According to one or more embodiment of the present disclosure, the array substrate further includes a light-shielding layer disposed on the side of the first active layer close to the substrate, and the second plate and the light-shielding layer are disposed in a same layer.

According to one or more embodiment of the present disclosure, the first gate layer is disposed on the side of the first active layer close to the substrate; the first plate and the first gate layer are disposed in a same layer and comprise a same material; and the second plate is disposed on a side of the first plate away from the substrate.

According to one or more embodiment of the present disclosure, the first thin film transistor is a dual-gate thin film transistor, and the first gate layer comprises a first gate sub-layer disposed on the side of the first active layer away from the substrate and a second gate sub-layer disposed on the side of the first active layer close to the substrate.

According to one or more embodiment of the present disclosure, the first plate and the first gate sub-layer are disposed in a same layer and comprise a same material, and the second plate is disposed on a side of the first plate away from the substrate or on a side of the first plate close to the substrate; or the first plate and the second gate sub-layer are disposed in a same layer and comprise a same material, and the second plate is disposed on the side of the first plate away from the substrate or on the side of the first plate close to the substrate.

According to one or more embodiment of the present disclosure, the substrate further has a non-display area, and the array substrate further includes a second thin film transistor disposed in the non-display area on the substrate; there is a gap between an orthographic projection of the second thin film transistor on the substrate and an orthographic projection of the first thin film transistor on the substrate; the second thin film transistor comprises a second active layer, and the first active layer is disposed on a side of the second active layer close to the substrate; a first gate insulating sub-layer and a second gate layer are disposed in sequence on a side of the second active layer away from the substrate; a second gate insulating sub-layer, a third gate insulating sub-layer and the first gate layer are disposed in sequence on the side of the first active layer away from the substrate; a fourth gate insulating sub-layer is disposed on the side of the second active layer close to the substrate; and the first gate insulating sub-layer and the third gate insulating sub-layer comprise a same material, and the second gate insulating sub-layer and the fourth gate insulating sub-layer comprise a same material.

According to one or more embodiment of the present disclosure, the second dielectric sub-layer is further disposed in the non-display area, and an orthographic projection of the second active layer on the substrate is within the orthographic projection of the second dielectric sub-layer on the substrate.

According to one or more embodiments of the present disclosure, a display panel includes: the array substrate described above; a metal connection layer disposed on a side of the first thin film transistor away from the substrate; and a pixel layer disposed on a side of the metal connection layer away from the substrate, the metal connection layer being electrically connected to the first source-drain layer and the pixel layer.

An array substrate and a display panel according to one or more embodiments of the present disclosure includes: a substrate having a pixel area and a capacitor area; a first thin film transistor disposed in the pixel area, the first thin film transistor including a first active layer, a first gate layer disposed on a side of the first active layer close to or away from the substrate, and a first source-drain layer disposed on a side of the first active layer away from the substrate, the first source-drain layer being electrically connected to the first active layer; and a first capacitor including a first plate, a second plate, and a first dielectric layer disposed between the first plate and the second plate, the first plate and the second plate (disposed in the capacitor area) being disposed on different layers, opposite to each other, the first dielectric layer including a first dielectric sub-layer, and a second dielectric sub-layer (disposed in the pixel area and the capacitor area) disposed on a side of the first dielectric sub-layer close to the first active layer. According to one or more embodiments of the present disclosure, the capacitance value of the first capacitor is increased, and the orthographic projection of the first active layer on the substrate is configured to be disposed in the orthographic projection of the second sub-dielectric layer on the substrate, thereby reducing the risk of failure of the first active layer.

### BRIEF DESCRIPTION OF THE DRAWINGS

FIGS. 1, 2, 3, 4, 5, 6, 7, 8 and 9 are respective schematic cross-sectional views of nine examples of a display panel according to the present disclosure.
FIGS. 10A, 10B and 10C are schematic diagrams of processes of a method of manufacturing a display panel according to one or more embodiments of the present disclosure.
FIGS. 11A, 11B and 11C are schematic diagrams of processes of another method of manufacturing a display panel according to one or more embodiments of the present disclosure.

### DETAILED DESCRIPTION

Some embodiments of the present disclosure will be described in detail below in connection with the accompanying drawings. The embodiments are described for illustrative purposes only and are not intended to limit the present disclosure.

In the description of the present disclosure, it is to be understood that the orientations or positional relationships indicated by terms "on", "below", "close", "far", and the like are based on the orientations or positional relationships shown in the accompanying drawings. For example, "on" indicates that a surface is above an object, that is, above an object level, such as directly above, obliquely above, and on a surface. Above orientations or positional relationships are only for ease of description of the present disclosure and simplification of the description, rather than indicating or implying that the device or element referred to must have a particular orientation, be constructed and operated in a particular orientation, and therefore should not be construed as limiting the present disclosure.

In addition, it is to be noted that the drawings provide only structures and steps in close relation to the present disclosure, and that details not substantially related to the present disclosure are omitted for the purpose of simplifying the drawings and making the present disclosure point clear, rather than indicating that in practice the device and method is same as in the drawings and is not intended to be limiting of the device and method in practice.

An array substrate and a display panel including the array substrate according to one or more embodiments of the present disclosure include, but are not limited to, the following embodiments and combinations of the following embodiments.

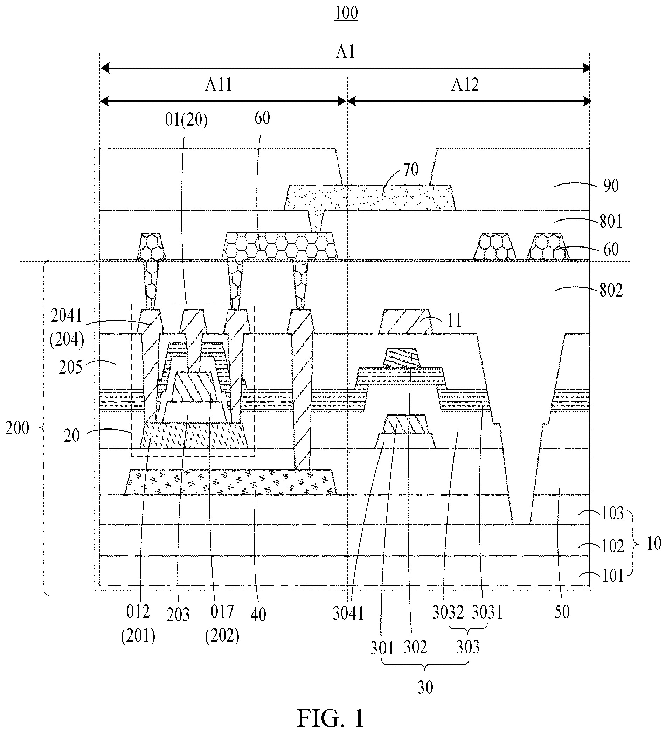

In one or more embodiments, as shown in FIGS. 1 to 9, both a display panel 100 and an array substrate 200 included by the display panel 100 include a display area A1 and a non-display area A2. Both the display panel 100 and the array substrate 200 include a substrate 10; a thin film transistor 20 disposed on the substrate 10 and opposite to at least one of the display area A1 and the non-display area A2, the thin film transistor 20 including an active layer 201, a gate layer 202 on a side of the active layer 201 close to or away from the substrate 10, and a source-drain layer 204 on a side of the active layer 201 away from the substrate 10, the source-drain layer 204 being electrically connected to the active layer 201; a first capacitor 30 disposed on the substrate 10 and opposite to the display area A1, the first capacitor 30 including a first plate 301 and a second plate 302 which are disposed in different layers and opposite each other, and a first dielectric layer 303 disposed between the first plate 301 and the second plate 302, the first dielectric layer 303 including a first dielectric sub-layer 3031 and a second dielectric sub-layer 3032 disposed on a side of the first dielectric sub-layer 3031 close to the active layer 201. Dielectric constant of the first dielectric sub-layer 3031 is greater than dielectric constant of the second dielectric sub-layer 3032, and an orthographic projection of the active layer 201 on the substrate 10 is in an orthographic projection of the second dielectric sub-layer 3032 on the substrate 10.

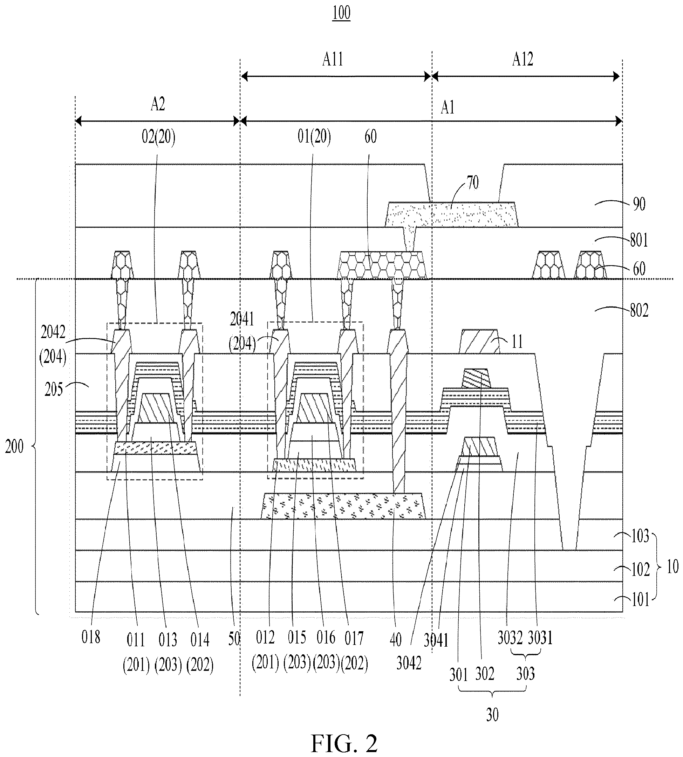

As shown in FIG. 2, a pixel area A11 and a capacitor area A12 may be defined in the display area A1, and the display area A1 may be provided with a transistor (i.e., a first thin film transistor 01) disposed in the pixel area A11 and used to drive a sub-pixel to emit light, and a corresponding storage capacitance (i.e., a first capacitance 30) disposed in the capacitor area A12. FIGS. 1 and 3 to 9 may be understood to illustrate only the display area A1. FIG. 2 further illustrates, with respect to FIGS. 1 and 3 to 7, a non-display area A2 disposed around the display area A1. The transistor in the display area A1 in FIG. 2 is specifically a first thin film transistor 01, and the transistor in the non-display area A2 in FIG. 2 is specifically a second thin film transistor 02.

**It** should be noted that "an orthographic projection of the active layer 201 on the substrate 10 is in an orthographic projection of the second dielectric sub-layer 3032 on the substrate 10" may be understood as follows:

**(1)** When the thin film transistor 20 includes at least the first thin film transistor 01, as shown in FIGS. 1 and 3 to 9, the second dielectric sub-layer 3032 extends from the capacitor area to the pixel area A11, and an orthographic projection of a first active layer 012 in the first thin film transistor 01 on the substrate 10 is disposed in the orthographic projection of the second dielectric sub-layer 3032 on the substrate 10; and

**(2)** When the thin film transistor 20 includes at least the second thin film transistor 02, as shown in FIG. 2, the second dielectric sub-layer 3032 extends from the capacitor area to the non-display area A2, and an orthographic projection of a second active layer 011 in the second thin film transistor 02 on the substrate 10 is disposed in the orthographic projection of the second dielectric sub-layer 3032 on the substrate 10.

As shown in FIGS. 1 and 3 to 9, a relative positional relationship between the first thin film transistor 01 and the first capacitor 30 is illustrated as an example. The first thin film transistor 01 includes the first active layer 012 (included in the active layer 201), a first gate layer 017 (included in the gate layer 202) disposed on a side of the first active layer 012 close to or away from the substrate 10, and a first source-drain layer 2041 (included in a source-drain layer 204) disposed on a side of the first active layer 012 away from the substrate 10 and electrically connected to the first active layer 012.

Specifically, as shown in FIGS. 1 to 7, the substrate 10 may include a glass substrate 101, a flexible substrate 102, and a barrier layer 103 which are laminated. The glass substrate 101 may me made of a material including, but not limited to, at least one of glass or quartz. The flexible substrate 102 may be made of a material including, but not limited to, a polyimide. The flexible substrate 102 may include a dual-layer flexible material and a buffer material disposed therebetween. The barrier layer 103 may be made of a material including, but not limited to, at least one of silicon nitride, silicon oxide, or silicon oxynitride. The barrier layer 103 may be used to prevent diffusion of impurity ions and permeation of moisture or external air, and may perform a surface planarization function.

As shown in FIGS. 1 to 7, the display panel 100 may include multiple thin film transistors 20 disposed on the substrate 10. The multiple thin film transistors 20 are electrically connected, and light emission of the display panel 100 may be realized by loading an electrical signal. Specifically, each thin film transistor 20 may include an active layer 201 for enabling on and off. The active layer 201 may be made of a material including amorphous silicon, polysilicon, or an oxide semiconductor. The polysilicon may include low-temperature polysilicon. The oxide semiconductor may include an oxide based on titanium (Ti), hafnium (Hf), zirconium (Zr), aluminum (Al), tantalum (Ta), germanium (Ge), zinc (Zn), gallium (Ga), tin (Sn), or indium (In), or any one of their composite oxides. The active layer 201 prepared by using low-temperature polysilicon technology may have a high electron mobility to have a high charging speed. The active layer 201 prepared by using amorphous silicon or oxide may have a low leakage current to reduce signal interference caused by leakage of the thin film transistor 20. Further, the active layer 201 may include a channel area, and doped areas disposed respectively at two ends of the channel area. The doped area may have a higher conductivity and a lower resistance than the channel area.

Specifically, as shown in FIGS. 1 to 7, a pixel drive circuit in the display panel 100 includes, in addition to the multiple first thin film transistors 01, a storage capacitor for storing a gray-scale voltage to determine a drive current. The first capacitor 30 in one or more embodiments may be used to constitute the above-mentioned storage capacitor. The first capacitor 30 may include a first plate 301, a second plate 302, and a first dielectric layer 303 disposed between the first plate 301 and the second plate 302. A capacitance value of the first capacitor 30 may be equal to ε*S/(4πkd), where ε is a dielectric constant of the first dielectric layer 303, S is an opposite area of the first plate 301 and the second plate 302, d is a distance between the first plate 301 and the second plate 302, and k is an electrostatic force constant.

It will be appreciated that in one or more embodiments, as to the first capacitor 30, the first dielectric layer 303 is provided to include the first dielectric sub-layer 3031 and the second dielectric sub-layer 3032 which are laminated, and dielectric constant of the first dielectric sub-layer 3031 is set to be greater than dielectric constant of the second dielectric sub-layer 3032. Compared to providing only the second dielectric sub-layer 3032 or another film layer between the two plates having a small dielectric constant, providing the first dielectric layer 303 having a large dielectric constant can effectively increase the dielectric constant ε of the first dielectric layer 303, so that the capacitance value of the first capacitor 30 is increased, thereby reducing the risk that luminance of a light-emitting device is reduced. Also, taking the first active layer 012 as an example in one or more embodiments, the second dielectric sub-layer 3032 having a small dielectric constant is provided on a side of the first dielectric sub-layer 3031 close to the first active layer 012, and the orthographic projection of the first active layer 012 on the substrate 10 is disposed in the orthographic projection of the second dielectric sub-layer 3032 on the substrate 10, so that impurities such as hydrogen elements can be effectively prevented from diffusing from above to the first active layer 012, thereby reducing the risk of failure of the first active layer 012.

Content of a hydrogen element in the second dielectric sub-layer 3032 may be considered to be lower than content of a hydrogen element in the first dielectric sub-layer 3031, and the second dielectric sub-layer 3032 may be considered to be more stable than the first dielectric sub-layer 3031. The second dielectric sub-layer 3032 may include a silicon element, an oxygen element, and a metal element, for example, may include but is not limited to silicon oxide. The dielectric constant of the first dielectric sub-layer 3031 may be greater than 4, and the first dielectric sub-layer 3031 may be made of a material including, but not limited to, at least one of aluminum oxide or zirconium oxide.

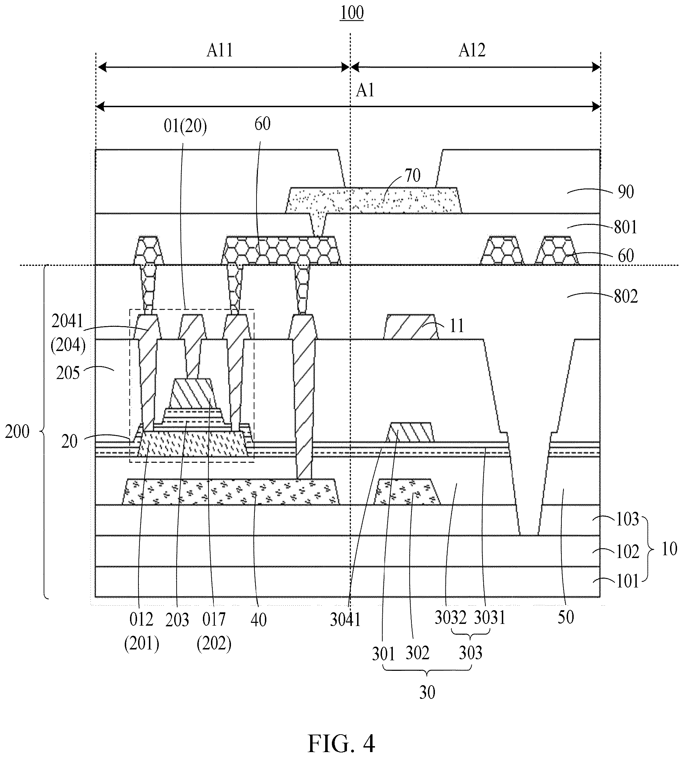

**In** one or more embodiments, as shown in FIGS. 1 to 4 and 9, taking the first gate layer 017 in the gate layer 202 as an example, the first gate layer 017 is provided on a side of the first active layer 012 away from the substrate 10, the first plate 301 is provided in a same layer as the first gate layer 017, and the first plate 301 and the first gate layer 017 are made of a same material. The second plate 302 is provided on a side of the first plate 301 away from (see FIGS. 1 to 3) or close to (see FIG. 4) the substrate 10.

The gate layer 202 (including the first gate layer 017) may be made of a material including, but not limited to, one or more metals selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), or copper (Cu). As shown in FIGS. 1 and 2, only the thin film transistor 20 is illustrated as a top gate structure in one or more embodiments. Specifically, a gate insulating layer 203 may be provided between the gate layer 202 and the active layer 201, and the gate insulating layer 203 is used to insulate the gate layer 202 and the active layer 201, so that the orthographic projection of the gate insulating layer 203 on the substrate 10 at least is beyond the orthographic projection of the gate layer 202 on the substrate 10. Of course, the gate insulating layer 203 may also extend beyond the active layer 201 and the buffer layer 50. The he gate insulating layer 203 may be made of a material including, but not limited to, a silicon compound, a metal oxide, and the like, for example, including at least one of a silicon oxide, a silicon nitride, a silicon oxynitride, an aluminum oxide, a tantalum oxide, a hafnium oxide, a zirconium oxide, or a titanium oxide.

**A** material of a source-drain layer 204 (including a first source-drain layer 2041) may refer to a material of the gate layer 202. The two materials may be same or different. The array substrate 200 may further include a wiring portion 11 provided in a same layer as the source-drain layer 204. The wiring portion 11 may be electrically connected to the first source-drain layer 2041 to realize signal transmission.

**As** shown in FIGS. 1 to 4, since conductivity of the gate layer 202 (including the first gate layer 017) is good, "the first plate 301 is provided in a same layer as the first gate layer 017" in one or more embodiments may be understood as that the first plate 301 and the first gate layer 017 are made of a same material at same time. Since the first active layer 012 is provided between the first gate layer 017 and the buffer layer 50, in a thickness direction of the film layer, a horizontal position in which the first gate layer 017 is disposed is higher than a horizontal position in which the first plate 301 is disposed. Further, if the gate insulating layer 203 is patterned and is disposed opposite to the first gate layer 017, an entire layer of a gate insulating film for post-forming the gate insulating layer 203 may be formed, the patterned first gate layer 017 and first plate 301 are formed on the gate insulating film in a process, and the gate insulating film is etched. The gate insulating film is shielded by the first gate layer 017 and the first plate 301, so that portions of the gate insulating film opposite to the first gate layer 017 and the first plate 301 are prevented from being etched to be retained, thereby forming the gate insulating layer 203 opposite to and below the first gate layer 017 and a first heightening portion 3041 opposite to and below the first plate 301. A thickness of the first heightening portion 3041 is close to a thickness of the gate insulating layer 203.

Specifically, as shown in FIGS. 1 to 3, the second plate 302 is disposed on a side of the first plate 301 away from the substrate 10 (a specific position of a film layer in which the second plate 302 is disposed is not limited here), and the first dielectric layer 303 is disposed on a side of the first active layer 012 away from the substrate 10. Since the first dielectric sub-layer 3031 having a larger dielectric constant is disposed further away from the substrate 10 than the second dielectric sub-layer 3032 having a smaller dielectric constant, the second dielectric sub-layer 3032 is disposed between the first dielectric sub-layer 3031 and the first active layer 012. A material of the second dielectric sub-layer 3032 includes silicon oxide, and the dielectric constant of the first dielectric sub-layer 3031 is larger (the material thereof may include but is not limited to aluminum oxide and zirconium oxide). The second dielectric sub-layer 3032 may be considered to have a more stable and compact property. Compared to only providing the first sub dielectric layer 3031, risk of impurities, such as a hydrogen element, diffusing from above to the first active layer 012 can be reduced.

Specifically, as discussed above, as shown in FIGS. 1 to 3, when the gate insulating layer 203 and the first gate layer 017 are disposed opposite each other, since the orthographic projection of the first active layer 012 on the substrate 10 extend beyond the orthographic projection of the gate insulating layer 203 on the substrate 10, two ends of the first active layer 012 cannot be shielded by the gate insulating layer 203, it is necessary to provide the second dielectric sub-layer 3032 completely beyond the first active layer 012 on a side of the first gate layer 017 away from the substrate 10, so as to reduce the influence of the diffusion of the hydrogen element on the first active layer 012.

**It** should be noted that the hydrogen element may be generated in a manufacturing process of the array substrate or other film layers in a corresponding display panel, or may be generated by an external environment, for example, water vapor in air.

Further, based on a top gate structure, as shown in FIGS. 1 to 3, the array substrate 200 further includes a light-shielding layer 40 disposed on a side of the first active layer 012 close to the substrate 10. The light-shielding layer 40 may be disposed opposite to the first active layer 012 for shielding light from being irradiated or reflected to the first active layer 012, thereby reducing the risk of failure of the first active layer 012. A material of the light-shielding layer 40 may include one or more metals selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), or copper (Cu). Still further, a buffer layer 50 may be provided between the light-shielding layer 40 and the first active layer 012, and a material of the buffer layer 50 may include, but is not limited to, at least one of silicon nitride (SiNx) or silicon oxide (SiOx) for preventing penetration of unnecessary components such as impurities or moisture.

In one or more embodiments, as shown in FIG. 2, the thin film transistor 20 includes a second thin film transistor 02 disposed in the non-display area A2 and a first thin film transistor 01 disposed in the pixel area A11 in the display area A1, and the active layer 201 includes a second active layer 011 of the second thin film transistor 02 and a first active layer 012 of the first thin film transistor 01. The second active layer 011 and the first active layer 012 are disposed on different layers, there is a gap between an orthographic projection of the second thin film transistor 02 on the substrate 10 and an orthographic projection of the first thin film transistor 01 on the substrate 10, and the first active layer 012 is disposed on a side of the second active layer 011 close to the substrate 10. a first gate insulating sub-layer 013 and a second gate layer 014 are provided on a side of the second active layer 011 away from the substrate 10 in sequence, a second gate insulating sub-layer 015, a third gate insulating sub-layer 016 and a first gate layer 017 are provided on a side of the first active layer 012 away from the substrate 10 in sequence, and a fourth gate insulating sub-layer 018 is provided on a side of the second active layer 011 close to the substrate 10. The first gate insulating sub-layer 013 and the third gate insulating sub-layer 016 are made of a same material, and the second gate insulating sub-layer 015 and the fourth gate insulating sub-layer 018 are made of a same material.

By such a configuration, based on a fact that the gate layer 202 includes the second gate layer 014 and the first gate layer 017 that are independently provided, the first plate 301, each of the second gate layer 014, and the first gate layer 017 may be provided in a same layer, and each of the first plate 301, the second gate layer 014, and the first gate layer 017 is made of a same material.

The second active layer 011 and the first active layer 012 may be made of different materials, so that the second thin film transistor 02 and the first thin film transistor 01 are respectively used to form different circuits, for example, may be respectively used to form a gate drive circuit and a pixel drive circuit. In this case, considering that the second thin film transistor 02 is disposed in the non-display area A2, no light is irradiated to the second active layer 011 of the second thin film transistor 02, so that it is no necessary to provide the light-shielding layer 40 below the second active layer 011. Therefore, in one or more embodiments, "the second active layer 011 and the first active layer 012 are disposed on different layers" may be understood as making the second active layer 011 and the first active layer 012 separately by different materials. For example, the first active layer 012 may be formed in a corresponding area, and then the second active layer 011 may be formed in another area. In order to prevent contact of two materials, the first active layer 012 may be formed first, and before the second active layer 011 is formed, a first kind of insulating material (that is, a material of the second gate insulating sub-layer 015, the fourth gate insulating sub-layer 018, and the first heightening portion 3041 described above) is formed on an entire surface. The second gate layer 014 and the first gate layer 017 may also be formed of a same material in a process. As can be seen from the above discussion, the first plate 301, the second gate layer 014, and the first gate layer 017 may be formed in a process, that is, provided in a same layer. Similarly, in order to prevent the material of the second gate layer 014 from being in contact with the material of the second active layer 011, a second kind of insulating material (i.e., a material the first gate insulating sub-layer 013, the third gate insulating sub-layer 016, and the second heightening portion 3042 disposed on the first heightening portion 3041) may be formed on an entire surface before the second gate layer 014 is formed.

Similarly, if the gate insulating layer 203 is patterned and is disposed opposite to the first gate layer 017, an entire layer of gate insulating film for post-forming the gate insulating layer 203 may be formed, the patterned first gate layer 017 (including the second gate layer 014 and the first gate layer 017) and first plate 301 are formed on the gate insulating film in a process, and the gate insulating film is etched. The gate insulating film is shielded by the first gate layer 017 and the first plate 301, so that portions of the gate insulating film opposite to the first gate layer 017 and the first plate 301 are prevented from being etched to be retained, thereby forming the gate insulating layer 203 (including a gate insulating sub-layer 013 opposite to and below the second gate layer 014, and a third gate insulating sub-layer 203 opposite to and below the first gate layer 017) below the first gate layer 017 and a second heightening portion 3042 below the first plate 301. A thickness of the second heightening portion 3042 is close to a thickness of a third gate insulating sub-layer 203.

Note that FIG. 2 only illustrates an example that both the second thin film transistor 02 and the first thin film transistor 01 are of a top gate structure, but at least one of the two may be of a bottom gate structure or a dual gate structure. The bottom gate structure and the dual gate structure may be discussed later.

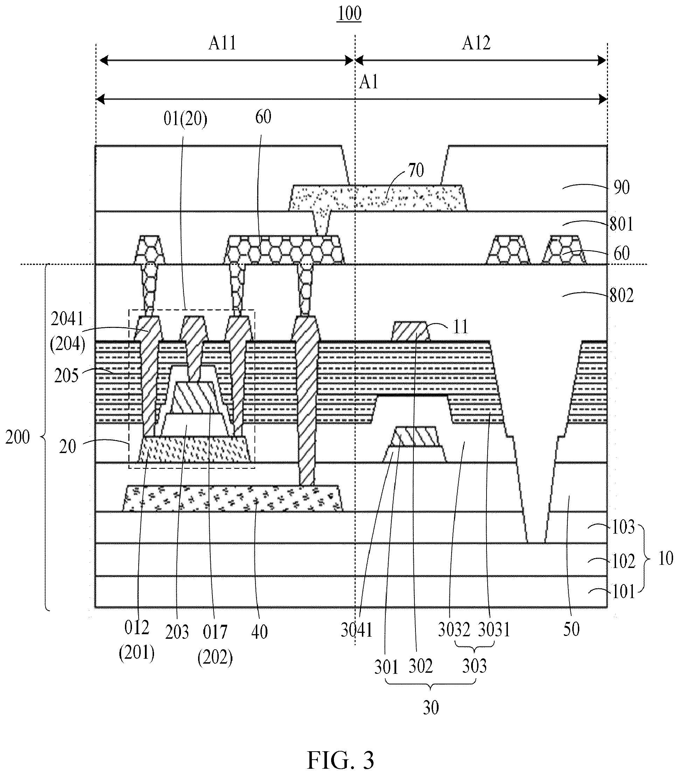

**In** one or more embodiments, taking the top gate structure as an example, the second plate is disposed on a side of the first plate away from the substrate. As shown in FIGS. 1 and 2, the second plate 302 is disposed between the first plate 301 and the first source-drain layer 204. Or as shown in FIG. 3, the second plate 302 and the first source-drain layer 204 are disposed in a same layer.

Specifically, as shown in FIGS. 1-3, the array substrate 200 may further include an interlayer insulating layer 205 disposed between the first gate layer 017 and the first source-drain layer 204. The interlayer insulating layer 205 is used to insulate the first gate layer 017 and the first source-drain layer 204, and may extend to the entire film layer to achieve planarization. The interlayer insulating layer 205 may be made of a material including, but not limited to, at least one of silicon oxide, silicon nitride, silicon oxynitride, aluminum oxide, tantalum oxide, hafnium oxide, zirconium oxide, or titanium oxide.

**It** will be appreciated that, as shown in FIGS. 1 and 2, the second plate 302 in one or more embodiments may be disposed between the first plate 301 and the first source-drain layer 204. For example, after formations of the first plate 301 and the first gate layer 017 in the first thin film transistor 01, and before formation of the first source-drain layer 204, the second plate 302 (which may be made of a material including metal and alloy, and also must be disposed below the interlayer insulating layer 205) is separately formed such that there may be a small distance between the first plate 301 and the second plate 302 to increase the capacitance value of the first capacitor 30. In this case, the second dielectric sub-layer 3032 and the first dielectric sub-layer 3031 may be provided on the first plate 301 in sequence.

**It** will be appreciated that, as shown in FIG. 3, the second plate 302 and the first source-drain layer 204 in one or more embodiment mays be provided in a same layer to save the number of processes. Also, since the second plate 302 is disposed on the interlayer insulating layer 205, the first dielectric sub-layer 3031 disposed on the second dielectric sub-layer 3032 may be multiplexed by the interlayer insulating layer 205, and material and structural characteristics of the interlayer insulating layer 205 need to take into account material and structural characteristics of both the interlayer insulating layer 205 and the first dielectric sub-layer 3031. Details may refer to the above discussion.

Specifically, taking the top gate structure as an example, as shown in FIG. 4, the second plate 302 is disposed on a side of the first plate 301 away from the substrate 10 (a specific position of a film layer on which the second plate 302 is disposed is not limited here), and the first dielectric layer 303 is also disposed on a side of the first active layer 012 away from the substrate 10. Further, as shown in FIG. 4, based on the presence of the gate insulating layer 203, the first dielectric layer 303 (i.e., the above-described first heightening portion 3041 opposite to and below the first plate 301) is provided in a same layer as the gate insulating layer 203. Further, the first dielectric layer 303 is formed by at least extending the gate insulating layer 203 to a side of the first plate 301 close to the substrate 10, that is, the first heightening portion 3041 and the gate insulating layer 203 may be integrally formed.

**It** will be appreciated that since the gate insulating layer 203 may also extend from the first active layer 012 to the side of the first plate 301 close to the substrate 10 to form the first dielectric layer 303, a separate manufacture of the first dielectric layer 303 may be prevented, saving the number of processes. The second plate 302 may be provided in a same layer as the light-shielding layer 40, that is, the second plate 302 and the light-shielding layer 40 are made of a same material and may be manufactured in a process, thereby further saving the number of processes. Still further, the second plate 302 is formed by extending the light-shielding layer 40 to be disposed opposite the first plate 301. The buffer layer 50 disposed on the light-shielding layer 40 may also be multiplexed as the first dielectric layer 303 since it is disposed between the first plate 301 and the second plate 302.

As shown in FIG. 4, in one or more embodiments, the first dielectric layer 303 may be disposed at at least one of following positions: between the first active layer 012 and the buffer layer 50, or between the buffer layer 50 and the light-shielding layer. Further, since the buffer layer 50 and the gate insulating layer 203 are in contact with a lower surface and an upper surface of the first active layer 012, respectively, protection effect of the buffer layer 50 and the gate insulating layer 203 on the first active layer 012 can be considered to be equivalent. Therefore, there is no restriction on which one of the buffer layer 50 and the gate insulating layer 203 is the first dielectric sub-layer 3031 and which one is the second dielectric sub-layer 3032. Material selections of the buffer layer 50 and the gate insulating layer 203 need to take into account the characteristics of the corresponding first dielectric sub-layer 3031 or the second dielectric sub-layer 3032. The buffer layer 50 may be multiplexed as the second dielectric sub-layer 3032 and the gate insulating layer 203 may be multiplexed as the first dielectric sub-layer 3031 in consideration of functions and characteristics of the gate insulating layer 203 and the buffer layer 50.

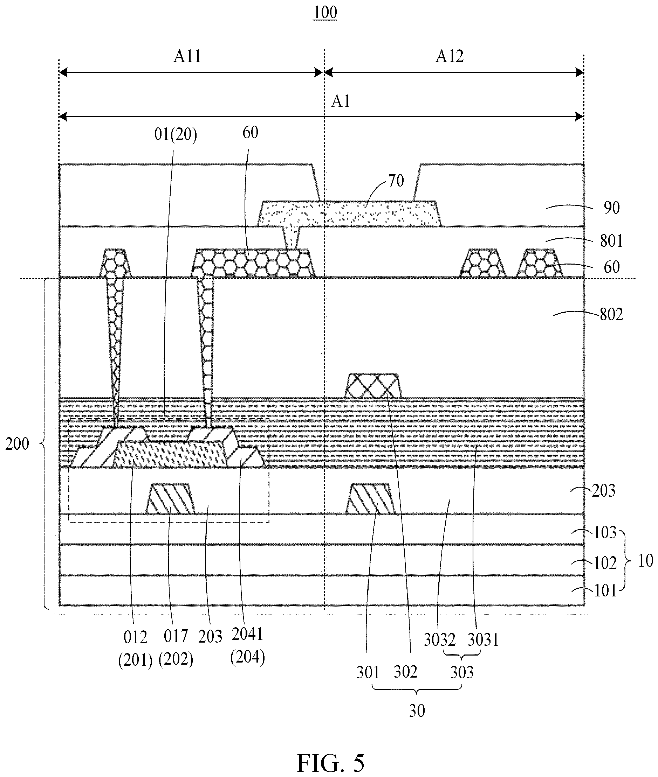

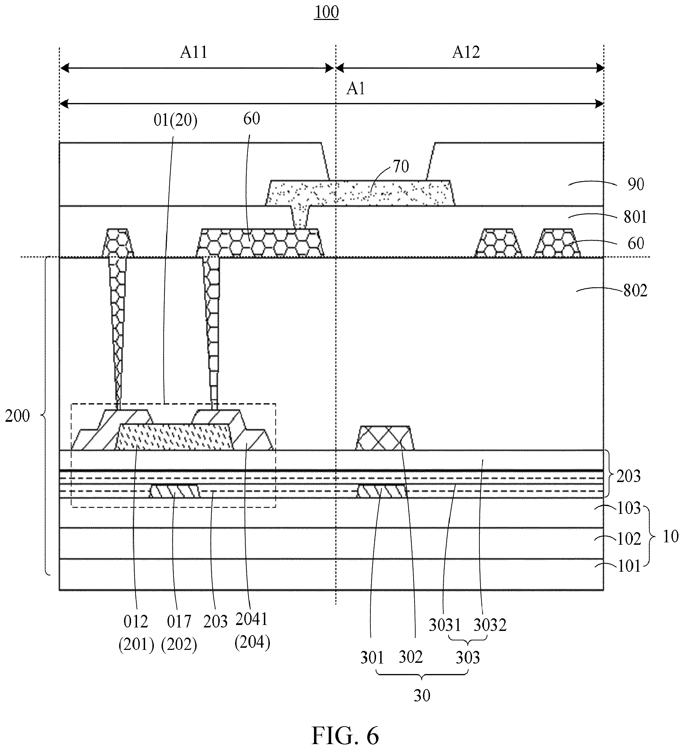

In one or more embodiments, as shown in FIGS. 5 and 6, the first thin film transistor 01 may also be of a bottom gate structure, that is, the first gate layer 017 is disposed on a side of the first active layer 012 close to the substrate 10, the first plate 301 and the first gate layer 017 are provided in a same layer and are made of a same material, and the second plate 302 is disposed on a side of the first plate 301 away from the substrate 10.

Further, as to the bottom gate structure, the orthographic projection of the first gate layer 017 in FIGS. 5 and 6 on the substrate 10 may be set larger so that the orthographic projection of the first active layer 012 on the substrate 10 is disposed the orthographic projection of the first gate layer 017 on the substrate 10, and the above-mentioned light-shielding layer is not needed. Similarly, a gate insulating layer 203 may be provided between the first gate layer 017 and the first active layer 012.

Since the first plate 301 and the first gate layer 017 are provided in a same layer, the second plate 302 may be disposed in a film layer above the first gate layer 017. For example, as shown in FIG. 5, the second plate 302 may be disposed above the first source-drain layer 204. Based on this, the first dielectric layer 303 may be disposed between the first source-drain layer 204 and the second plate 302 to achieve both formation of the first capacitor 30 and insulation between the first source-drain layer 204 and the second plate 302. Further, the gate insulating layer 203 may also be provided to achieve both formation of the first dielectric layer 303 and insulation between the first gate layer 017 and the first active layer 012. Only the first dielectric sub-layer 3031 is disposed between the first source-drain layer 204 and the second plate 302, and the gate insulating layer 203 is multiplexed as the second dielectric sub-layer 3032 are illustrated as an example, which is not limited herein (because the first dielectric sub-layer 3031 and the second dielectric sub-layer 3032 are in contact with an upper surface and a lower surface of the first active layer 012, respectively). For another example, as shown in FIG. 6, the second plate 302 may be provided in a same layer as the first source-drain layer 204, the gate insulating layer 203 may be provided to include the first dielectric sub-layer 3031 and the second dielectric sub-layer 3032, and the second dielectric sub-layer 3032 may be provided closer to the first active layer 012.

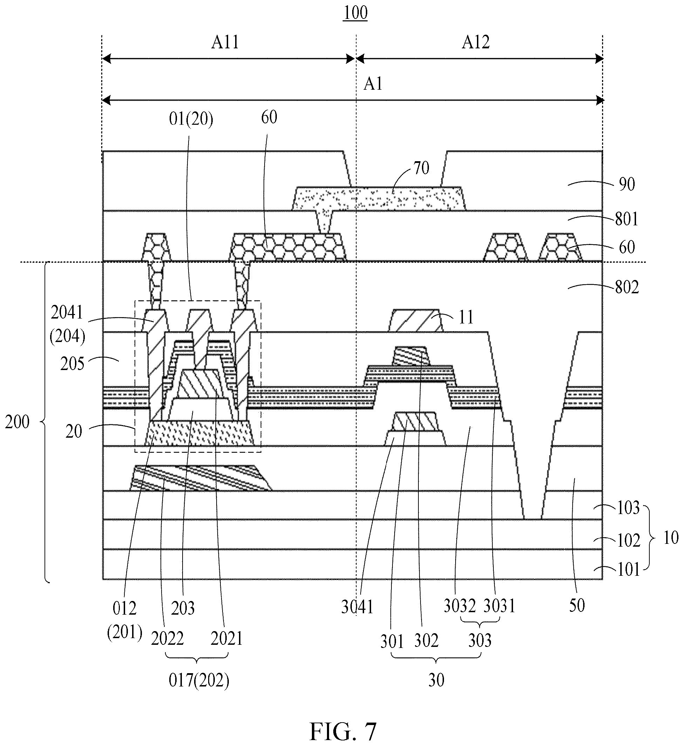

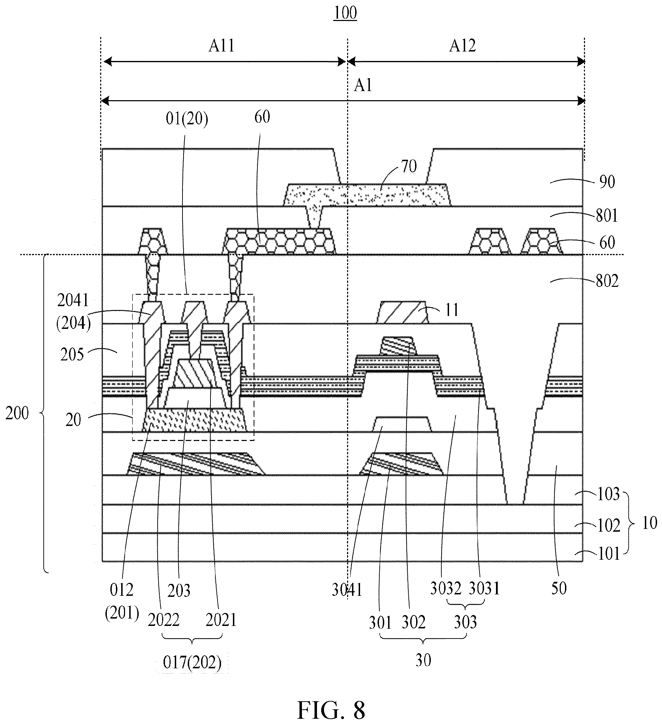

In one or more embodiments, as shown in FIGS. 7 and 8, the first thin film transistor 01 is a dual-gate thin film transistor including a first gate sub-layer 2021 disposed on the first active layer 012 away from the substrate 10, and a second gate sub-layer 2022 disposed on the first active layer 012 close to the substrate 10.

Here, the dual-gate thin film transistor has two gates (i.e., the first gate sub-layer 2021 and the second gate sub-layer 2022) as a control gate and a feedback gate, respectively. By applying a certain voltage between the control gate (one of the first gate sub-layer 2021 and the second gate sub-layer 2022) and the source, the current flow between the source and the drain in the dual-gate thin film transistor can be controlled. By applying a certain voltage between the feedback gate (another of the first gate sub-layer 2021 and the second gate sub-layer 2022) and the source, the current flow between the control gate and the source can be controlled. Thus, control over a whole dual-gate thin film transistor is achieved. The dual-gate thin film transistor has advantages of low power consumption, high speed, and the like.

In one or more embodiments, as shown in FIG. 7, the first plate 301 and the first gate sub-layer 2021 are disposed in a same layer and are made of a same material, and the second plate 302 is disposed on a side of the first plate 301 away from or close to the substrate 10 (details may refer to one or more embodiments according to FIGS. 1 to 5. FIG. 7 only illustrates that the second plate 302 is disposed on a side of the first plate 301 away from the substrate 10). Alternatively, as shown in FIG. 8, the first plate 301 and the second gate sub-layer 2022 are disposed in a same layer and are made of a same material, and the second plate 302 is disposed on a side of the first plate 301 away from or close to the substrate 10 (details may refer to one or more embodiments according to FIGS. 1 to 5. FIG. 8 only illustrates that the second plate 302 is disposed on a side of the first plate 301 away from the substrate 10).

Regardless of whether the first plate 301 is provided in a same layer as the first gate sub-layer 2021 or the second gate sub-layer 2022, if the second plate 302 is disposed on a side of the first plate 301 close to the substrate 10, the second plate 302 may be considered to be disposed between the substrate 10 and the first plate 301, and the first dielectric layer 303 is disposed between the first plate 301 and the second plate 302.

As shown in FIGS. 1 to 9, in addition to the array substrate 200 as described above, the display panel 100 according to one or more embodiments of the present disclosure further includes a metal connection layer 60 disposed on a side of the first thin film transistor 01 (the first source-drain layer 204 therein) away from the substrate 10; a pixel layer (including an anode layer 70) disposed on a side of the metal connection layer 60 away from the substrate 10, and the metal connection layer 60 is electrically connected to the first source-drain layer 204 and the pixel layer (an anode layer 70 therein).

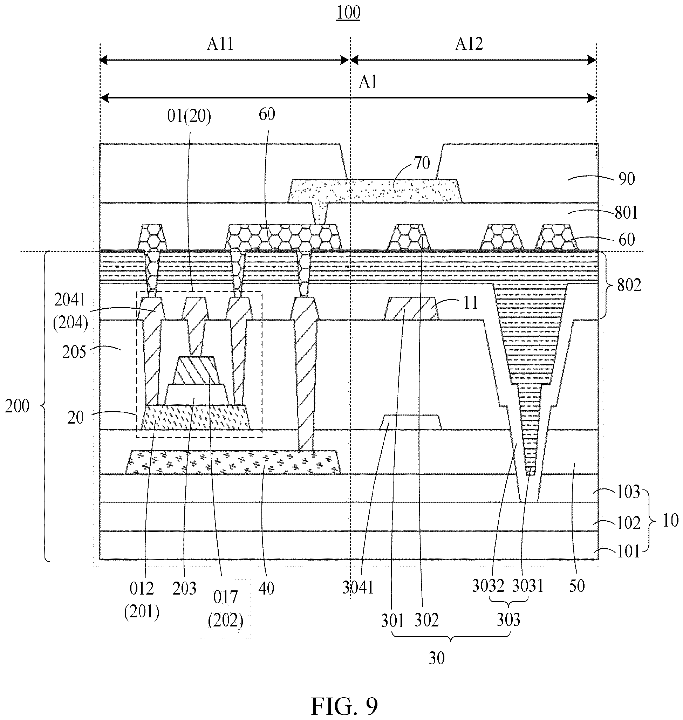

In one or more other alternative embodiments, as shown in FIG. 9, both the first plate 301 and the second plate 302 may be disposed on the first gate layer 017, for example, the first plate 301 and a first source-drain layer 2041 (included in the source-drain layer 204) may be disposed in a same layer, and the second plate 302 and the metal connection layer 60 may be disposed in a same layer. Accordingly, a second planarization layer 802 disposed between the first source-drain layer 204 and the metal connection layer 60 may include a first dielectric sub-layer 3031 and a second dielectric sub-layer 3032, and the second dielectric sub-layer 3032 may be provided closer to the first active layer 012.

Specifically, as shown in FIGS. 1 to 9, the display panel 100 may further include a first planarization layer 801 covering the metal connection layer 60 for planarization. The first planarization layer 801 is generally large in thickness and may be used to provide a planarization surface for the deposition of the anode layer 70. The first planarization layer 801 may be made of a material including, but not limited to, at least one of an inorganic insulating material, an organic insulating material such as polyacrylatesresin, epoxy resin, phenolic resin, polyamidesresin, polyimides resin, unsaturatedpolyesters resin, poly phenylenethers resin, polyphenylenesulfides resin, benzocyclobutene, or the like, or a photosensitive material. Further, the display panel 100 may further include a pixel definition layer 90 disposed on the first planarization layer 801, the pixel definition layer 90 may be formed with multiple openings, and a corresponding anode layer 70 may be provided in each opening. Further, a second planarization layer 802 may be provided between the metal connection layer 60 and the first source-drain layer 204, and the second planarization layer 802 is also generally large in thickness, and may be used to provide a planarization surface for the deposition of the metal connection layer 60. A material of the second planarization layer 802 may refer to the above description regarding the material of the first planarization layer 801.

Further, in connection with one or more embodiments shown in FIG. 3 and one or more embodiments shown in FIG. 5, according to one or more embodiments, the first plate 301 and the first source-drain layer 204 (included in the source-drain layer 204) are disposed in a same layer, and the second plate 302 may be modified to be disposed in a same layer as the metal connection layer 60, that is, the second plate 302 and the metal connection layer 60 are manufactured on the second planarization layer 802 in a process so as to save the number of processes. As discussed above, the second planarization layer 802 may include the first dielectric sub-layer 3031 and the second dielectric sub-layer 3032.

Of course, compared to one or more embodiments shown in FIG. 9, the first plate 301 may be modified to be provided in a same layer as the anode layer 70. It will be appreciated that the first plate 301 and the anode layer 70 may be manufactured in a same layer in a process so as to save the number of processes. In this case, the first planarization layer 801 may be provided with the first dielectric sub-layer 3031 and the second dielectric sub-layer 3032 as described above.

**It** should be noted that only the possibilities of various configurations of the first capacitor 30 are discussed above. In practice, on the basis of the above-mentioned first capacitor 30, a second capacitor (not shown) may also be provided on the substrate 10, and the second capacitor includes a third plate, a fourth plate, and a second dielectric layer disposed between the third plate and the fourth plate, which are disposed in different layers and oppositely. Based on specific film layers of the light-shielding layer 40, the metal connection layer 60, and the first thin film transistor 01 discussed above, unlike the configuration of the first capacitor 30 described above, the second dielectric layer in the second capacitor may not be configured as the first dielectric layer, but may include only the film layer between the third plate and the fourth plate. For example, the third plate may be disposed in a same layer as one of the light-shielding layer 40, the metal connection layer 60, the gate layer 202, and the source-drain layer 204. The fourth plate may be disposed in a same layer as another of the light-shielding layer 40, the metal connection layer 60, the gate layer 202, and the source-drain layer 204, or the fourth plate may be disposed in a same layer as the film layer between the source-drain layer 204 and the gate layer 202.

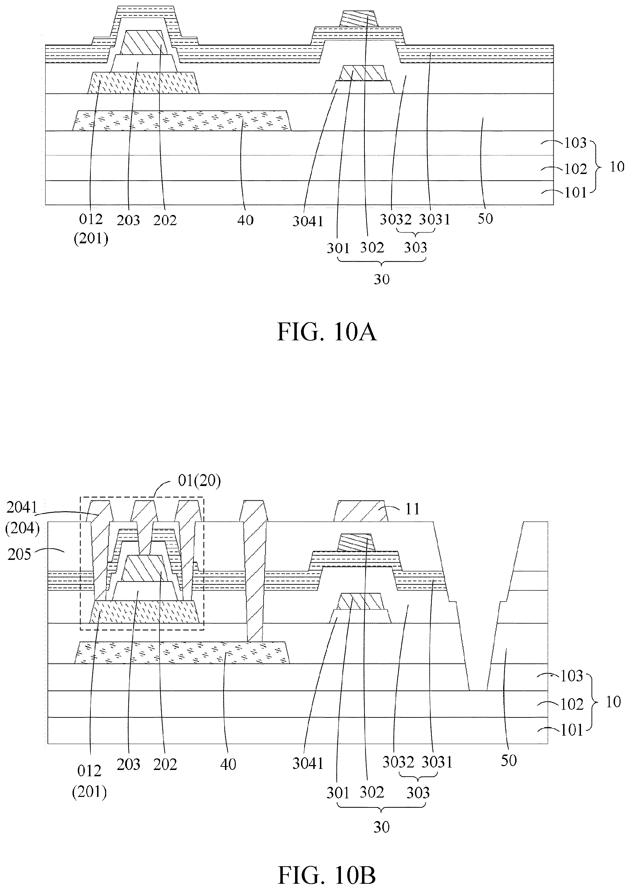

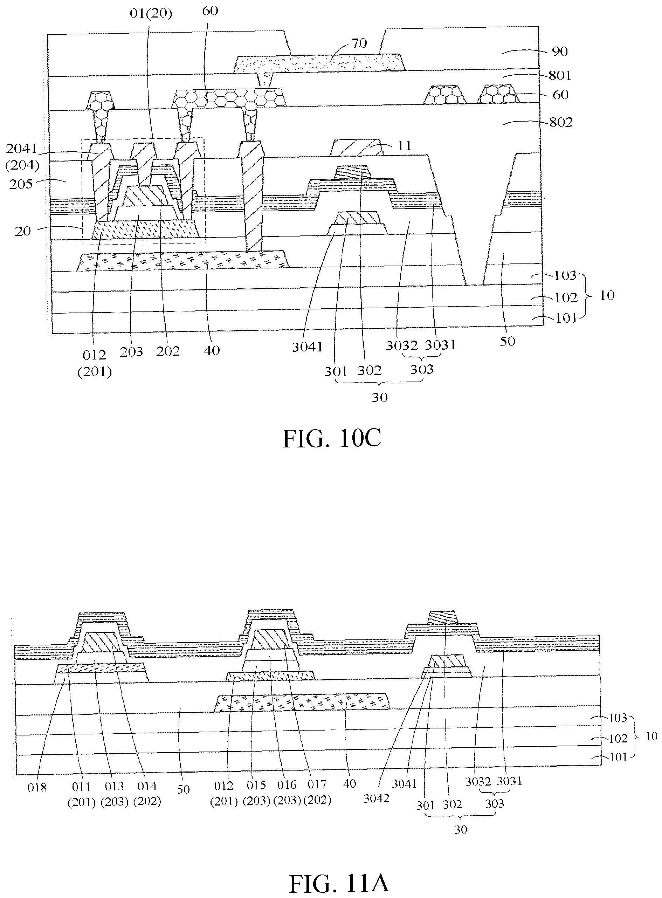

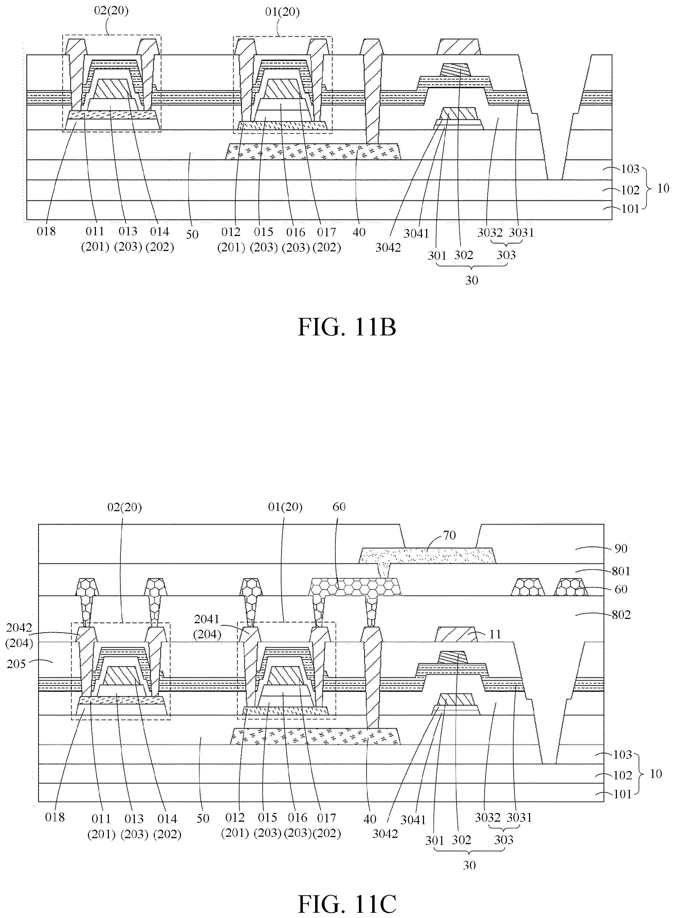

In order to better describe a film layer structure of the display panel described above, according to one or more embodiments of the present disclosure, a method of manufacturing the display panel includes but is not limited to the following steps and combinations thereof. Description is made below in connection with schematic diagrams of processes shown in FIGS. 10A, 10B, and 10C and schematic diagrams of processes shown in FIGS. 11A, 11B, and 11C, and may be used to form the display panel shown in FIGS. 1 and 2, respectively.

At a first step, a substrate is provided.

Specifically, as shown in FIGS. 10A to 10C, and FIGS. 11A to 11C, specific structure and material of the substrate 10 may refer to the above related discussion.

At a second step, the substrate is cleaned, and a layer of metal material having a thickness of 1000 to 10000 angstroms is deposited and is patterned to form a light-shielding layer.

Specifically, as shown in FIGS. 10A to 10C, and FIGS. 11A to 11C, the material of the light-shielding layer 40 may refer to the above related discussion, and further, may include, but is not limited to, at least one of Mo, Cr, Al, Cu, or Ti.

And a third step, a single layer or multiple layers of inorganic material is deposited on the light-shielding layer to form a buffer layer.

Specifically, as shown in FIG. 10A to FIG. 10C, and FIG. 11A to FIG. 11C, the material of the buffer layer 50 may refer to the above related discussion. Further, the buffer layer 50 may be a single-layer silicon nitride (SiNx) film layer, a single-layer silicon oxide (SiOx) film layer or a stacked silicon nitride (SiNx) film layer, or a silicon oxide (SiOx) film layer. Thickness of the buffer layer 50 ranges from 1000 to 5000 angstroms.

At a fourth step, a layer of metal oxide is deposited on the buffer layer and is patterned to form a first active layer.

Specifically, as shown in FIGS. 10A to 10C, and FIGS. 11A to 11C, the material of the first active layer 012 may refer to the above related discussion. Further, the metal oxide herein may include, but is not limited to, at least one of IGTO, ITZO, or IGZTO, and the thickness of the first active layer 012 may be 100 to 1000 angstroms. In particular, as shown in FIG. 5, it is considered that the first active layer 012 in the first thin film transistor 01 is formed.

At a fifth step, an inorganic material is deposited on the first active layer to form a gate insulating layer.

As shown in FIG. 10A to FIG. 10C, and FIG. 11A to FIG. 11C, the film layer of the inorganic material used to form the gate insulating layer 203 may include, but is not limited to, a single-layer silicon nitride (SiNx) film layer, a single-layer silicon oxide (SiOx) film layer, a stacked silicon nitride (SiNx) film layer, or a stacked silicon oxide (SiOx) film layer. As shown in FIG. 10, the thickness of the gate insulating layer 203 may be 1000 to 3000 angstroms. As shown in FIG. 11, in this case, it may be considered that the gate insulating layer 203 (the second gate insulating sub-layer 015) in the first thin film transistor 01 is formed, the thickness thereof may be 500 to 2000 angstroms, and forming the fourth gate insulating sub-layer 018 as discussed above.

Further, for FIGS. 11A to 11C, after step S05, the method further includes forming the second active layer 011 in the second thin film transistor 02, and the thickness and material of the second active layer 011 may refer to related description of the first active layer 012 mentioned above. Further, after forming the second active layer 011, the method further includes forming the first gate insulating sub-layer 013 in the second thin film transistor 02, the thickness thereof may be 1000 to 3000 angstroms, and forming third gate insulating sub-layer 016 as discussed above.

At a sixth step, a layer of metal material for forming the gate layer is deposited on the film layer of the inorganic material for forming the gate insulating layer.

Specifically, the material of the gate layer 202 (including the first gate layer 017 in FIGS. 10Ato 10C, and FIG. 11A to 11C, and the second gate layer 014 in FIGS. 11A to 11C) may refer to the above related discussion. Further, the material of the gate layer 202 may include, but is not limited to, at least one of Mo, Al, Cu, or Ti, and the thickness of the gate layer 202 may be 2000 to 8000 angstroms.

At a seventh step, the metal material used to form the gate layer is etched by a yellow light process to form the gate layer, and the inorganic material used to form the gate insulating layer is etched by self-aligning a metal pattern of the gate layer to form the gate insulating layer 203.

As can be appreciated, as shown in FIGS. 10A to 10C, and FIGS. 11A to 11C, the gate insulating layer 203 is present only below the metal pattern of the gate layer 202, and the inorganic material in other areas is etched away. Further, a plasma treatment on an entire surface may be selected to improve the conductivity of the exposed oxide area in the active layer 201. As discussed above, the first plate 301 and the gate layer 202 may be formed by a same patterning. Similarly, as shown in FIG. 10, before this, a corresponding first heightening portion 3041 provided in a same layer as the gate insulating layer 203 is formed below the first plate 301.

In particular, as shown in FIGS. 11A to 11C, the second gate layer 014 in the second thin film transistor 02 and the first gate layer 017 in the first thin film transistor 01 may be formed at a same step. Similarly, as shown in FIG. 5, before the step, the first heightening portion 3041 opposite to and below the first electrode plate 301 and disposed in a same layer as the fourth gate insulating sub-layer 018 and the second gate insulating sub-layer 015 is formed, and the second heightening portion 3042 opposite to and below the first electrode plate 301 and disposed in a same layer as the first gate insulating sub-layer 013 and the third gate insulating sub-layer 016 is formed.

At an eighth step, an insulating material is deposited to form a second dielectric sub-layer.

As shown in FIGS. 10A to 10C, and FIGS. 11A to 11C, the material of the second dielectric sub-layer 3032 may include, but is not limited to, silicon oxide, and the thickness of the second dielectric sub-layer 3032 may be 500 to 2000 angstroms.

At a ninth step, a layer of insulating material is deposited on the second dielectric sub-layer to form the first dielectric sub-layer.

As shown in FIGS. 10A to 10C and 11A to 11C, dielectric constant of the first dielectric sub-layer 3031 may be greater than 4, and the material of the first dielectric sub-layer 3031 may refer to related description mentioned above. As shown in FIG. 4, the thickness of the first dielectric sub-layer 3031 may be 800 to 3000 angstroms. As shown in FIG. 5, the thickness of the first dielectric sub-layer 3031 may be 500 to 3000 angstroms.

At a tenth step, a layer of metal material is deposited on the first dielectric sub-layer and patterned to form a second plate.

As shown in FIGS. 10A to 10C, and FIGS. 11A to 11C, the material of the second plate 302 may refer to related description mentioned above, for example, may include, but is not limited to, at least one of Mo, Al, Cu, or Ti, and the thickness of the second plate 302 may be 2000 to 8000 angstroms.

At an eleventh step, an insulating material is deposited on the second plate and the first dielectric sub-layer to form an interlayer insulating layer, and a first via hole penetrating at least the interlayer insulating layer is formed.

As shown in FIGS. 10A to 10C, and FIGS. 11A to 11C, the interlayer insulating layer 205 may include, but is not limited to, a single-layer silicon nitride (SiNx) film layer, a single-layer silicon oxide (SiOx) film layer, a stacked silicon nitride (SiNx) film layer, or a stacked silicon oxide (SiOx) film layer.

At a twelfth step, a metal material is deposited on the interlayer insulating layer and in the first via hole, and is patterned to form a source-drain layer.

The material of the source-drain layer 204 (including the first source-drain layer 2041 shown in FIGS. 10A to 10A, and FIGS. 11 Ato 11C, and the second source-drain layer 2042 shown in FIGS. 11A to 11C) may refer to related description mentioned above, for example, may include, but is not limited to, at least one of Mo, Al, Cu, or Ti. The thickness of the source-drain layer 204 may be 2000 to 8000 angstroms, and the source-drain layer 204 may be electrically connected to the active layer 201 and the light-shielding layer 40 through the metal material in the first via hole.

At a thirteenth step, an insulating material is deposited on the source-drain layer and the interlayer insulating layer to form a passivation layer.

The passivation layer may include, but is not limited to, a single-layer silicon nitride (SiNx) film layer, a single-layer silicon oxide (SiOx) film layer, a stacked silicon nitride (SiNx) film layer, or a stacked silicon oxide (SiOx) film layer, and the thickness of the passivation layer may be 1000 to 5000 angstroms. Further, as shown in FIGS. 10A to 10C and 11A to 11C, the second planarization layer 802 may be formed on the passivation layer, and the material of the second planarization layer 802 may refer to related description mentioned above. Further, a second via hole may be formed in the second planarization layer 802.

At S14, an anode layer is formed on the passivation layer.

As shown in FIGS. 10Ato 10C, and FIGS. 11A to 11C, the material of the anode layer 70 may refer to related description mentioned above. As discussed above, the second planarization layer 802, the metal connection layer 60, the first planarization layer 801, and the pixel definition layer 90 may be formed on the passivation layer before the anode layer 70 is formed.

Specifically, the above display panel 100 may be used as a liquid crystal display panel, a submillimeter light-emitting diode (Mini LED), a micro light-emitting diode display (Micro LED), or an organic light-emitting semiconductor.

An array substrate and a display panel according to one or more embodiments of the present disclosure includes a substrate having a pixel area and a capacitor area; a first thin film transistor disposed in the pixel area on the substrate, including a first active layer, a first gate layer disposed on a side of the first active layer close to or away from the substrate, and a first source-drain layer disposed on a side of the first active layer away from the substrate, the first source-drain layer being electrically connected to the first active layer; a first capacitor including a first plate and a second plate (disposed in the capacitive area on the substrate) which are disposed on different layers and opposite to each other, and a first dielectric layer between the first plate and the second plate, the first dielectric layer including a first dielectric sub-layer, and a second dielectric sub-layer (disposed in the pixel area and the capacitive area) disposed on a side of the first dielectric sub-layer close to the first active layer. According to one or more embodiments of the present disclosure, the dielectric constant of the first dielectric sub-layer is set to be greater than the dielectric constant of the second dielectric sub-layer to increase the capacitance value of the first capacitor, and the orthographic projection of the first active layer on the substrate is configured to be disposed in the orthographic projection of the second dielectric sub-layer on the substrate to reduce the risk of failure of the first active layer.

Some embodiments of the present disclosure have been described in detail above. The description of the above embodiments merely aims to help to understand the present disclosure. Many modifications or equivalent substitutions with respect to the embodiments may occur to those of ordinary skill in the art based on the present disclosure. Thus, these modifications or equivalent substitutions shall fall within the scope of the present disclosure.

## Claims

1. An array substrate, comprising:
a substrate having a pixel area and a capacitor area;
a first thin film transistor disposed in the pixel area on the substrate, the first thin film transistor comprising a first active layer, a first gate layer disposed on a side of the first active layer close to the substrate or on a side of the first active layer away from the substrate, and a first source-drain layer disposed on the side of the first active layer away from the substrate, the first source-drain layer being electrically connected to the first active layer; and
a first capacitor disposed on the substrate, the first capacitor comprising a first plate, a second plate, and a first dielectric layer disposed between the first plate and the second plate,
wherein the first plate and the second plate are disposed respectively in different layers to be opposite to each other in the capacitor area;
the first dielectric layer comprises a first dielectric sub-layer and a second dielectric sub-layer disposed on a side of the first dielectric sub-layer close to the first active layer, the second dielectric sub-layer being disposed in the pixel area and the capacitor area;
a dielectric constant of the first dielectric sub-layer is greater than a dielectric constant of the second dielectric sub-layer; and
an orthographic projection of the first active layer on the substrate is within an orthographic projection of the second dielectric sub-layer on the substrate.

2. The array substrate according to claim 1, wherein the first dielectric sub-layer comprises at least one of aluminum oxide or zirconium oxide, and the second dielectric sub-layer comprises silicon oxide.

3. The array substrate according to claim 1, wherein the first gate layer is disposed on the side of the first active layer away from the substrate;
the first plate and the first gate layer are disposed in a same layer and comprise a same material; and
the second plate is disposed on a side of the first plate away from the substrate or on a side of the first plate close to the substrate.

4. The array substrate according to claim 3, wherein the second plate is disposed on the side of the first plate away from the substrate; and
the second plate is disposed between the first plate and the first source-drain layer, or the second plate and the first source-drain layer are disposed in a same layer.

5. The array substrate according to claim 3, wherein the second plate is disposed on the side of the first plate close to the substrate;
the first thin film transistor further comprises a gate insulating layer disposed between the first active layer and the first gate layer to be opposite to the first gate layer; and
the first dielectric layer and the gate insulating layer are disposed in a same layer.

6. The array substrate according to claim 5, further comprising a light-shielding layer disposed on the side of the first active layer close to the substrate,
wherein the second plate and the light-shielding layer are disposed in a same layer.

7. The array substrate according to claim 1, wherein the first gate layer is disposed on the side of the first active layer close to the substrate;
the first plate and the first gate layer are disposed in a same layer and comprise a same material; and
the second plate is disposed on a side of the first plate away from the substrate.

8. The array substrate according to claim 1, wherein the first thin film transistor is a dual-gate thin film transistor, and the first gate layer comprises a first gate sub-layer disposed on the side of the first active layer away from the substrate and a second gate sub-layer disposed on the side of the first active layer close to the substrate.

9. The array substrate according to claim 8, wherein the first plate and the first gate sub-layer are disposed in a same layer and comprise a same material, and the second plate is disposed on a side of the first plate away from the substrate or on a side of the first plate close to the substrate; or
the first plate and the second gate sub-layer are disposed in a same layer and comprise a same material, and the second plate is disposed on the side of the first plate away from the substrate or on the side of the first plate close to the substrate.

10. The array substrate according to any one of claims 1 to 9, wherein the substrate further has a non-display area, and the array substrate further comprises a second thin film transistor disposed in the non-display area on the substrate;
there is a gap between an orthographic projection of the second thin film transistor on the substrate and an orthographic projection of the first thin film transistor on the substrate;
the second thin film transistor comprises a second active layer, and the first active layer is disposed on a side of the second active layer close to the substrate;
a first gate insulating sub-layer and a second gate layer are disposed in sequence on a side of the second active layer away from the substrate;
a second gate insulating sub-layer, a third gate insulating sub-layer and the first gate layer are disposed in sequence on the side of the first active layer away from the substrate;
a fourth gate insulating sub-layer is disposed on the side of the second active layer close to the substrate; and
the first gate insulating sub-layer and the third gate insulating sub-layer comprise a same material, and the second gate insulating sub-layer and the fourth gate insulating sub-layer comprise a same material.

11. The array substrate of claim 10, wherein the second dielectric sub-layer is further disposed in the non-display area, and an orthographic projection of the second active layer on the substrate is within the orthographic projection of the second dielectric sub-layer on the substrate.

12. A display panel, comprising:
the array substrate according to any one of claims 1 to 11;
a metal connection layer disposed on a side of the first thin film transistor away from the substrate; and
a pixel layer disposed on a side of the metal connection layer away from the substrate,
wherein the metal connection layer is electrically connected to the first source-drain layer and the pixel layer;
the first plate and the second plate are disposed respectively in different layers to be opposite to each other in the capacitor area;
the first dielectric layer comprises a first dielectric sub-layer and a second dielectric sub-layer disposed on a side of the first dielectric sub-layer close to the first active layer, the second dielectric sub-layer being disposed in the pixel area and the capacitor area;
a dielectric constant of the first dielectric sub-layer is greater than a dielectric constant of the second dielectric sub-layer; and
an orthographic projection of the first active layer on the substrate is within an orthographic projection of the second dielectric sub-layer on the substrate.
